Europäisches Patentamt

European Patent Office

Office européen des brevets

(11) Veröffentlichungsnummer: **0 070 461**
**B1**

# (12) EUROPÄISCHE PATENTSCHRIFT

(45) Veröffentlichungstag der Patentschrift:
11.06.86

(21) Anmeldenummer: 82106102.5

(22) Anmeldetag: 08.07.82

(51) Int. Cl.⁴: **H 03 K 21/08, H 03 K 21/18**

(54) Zähler mit nichtflüchtiger Speicherung.

(30) Priorität: 16.07.81 DE 3128127

(43) Veröffentlichungstag der Anmeldung:
26.01.83 Patentblatt 83/4

(45) Bekanntmachung des Hinweises auf die Patenterteilung:
11.06.86 Patentblatt 86/24

(84) Benannte Vertragsstaaten:
DE FR GB IT NL

(56) Entgegenhaltungen:
US - A - 1 322 869
US - A - 3 588 459
US - A - 3 820 073

(73) Patentinhaber: Deutsche ITT Industries GmbH,
Hans-Bunte-Strasse 19 Postfach 840, D-7800 Freiburg
(DE)

(84) Benannte Vertragsstaaten: DE

(73) Patentinhaber: ITT INDUSTRIES INC., 320 Park Avenue,
New York, NY 10022 (US)

(84) Benannte Vertragsstaaten: FR GB IT NL

(72) Erfinder: Wilmsmeyer, Klaus, Dr.rer.nar., Stuttgarter
Strasse 10/1, D-7809 Denzlingen (DE)

(74) Vertreter: Morstadt, Volker, Dipl.-Ing., c/o Deutsche ITT
Industries GmbH Patent/Lizenzabteilung
Postfach 840 Hans-Bunte-Strasse 19,
D-7800 Freiburg/Brsg. (DE)

## Beschreibung

Mit Hilfe von nichtflüchtig lesbaren elektrisch programmierbaren Halbleiterspeicherelementen, wie MNOS-Transistoren oder Floating-Gate-Transistoren, ist es möglich, Informationen, die sich von Zeit zu Zeit ändern, elektrisch so zu speichern, daß sie auch bei Ausfall der Versorgungsspannung beibehalten werden. Beispiele von Speicherzellen mit solchen elektrisch programmierbaren Halbleiterbauelmenten finden sich in den deutschen Auslegeschriften 24 42 131, 24 42 132 und 24 42 134.

Eines der einfachsten Beispiele für einen Zähler mit nichtflüchtiger Speicherung ist ein mechanischer Zähler, wie der beispielsweise als Betriebsstundenzähler oder Kilometerzähler gebraucht wird. Er ist als Speicher für ein n-stelliges Digitalwort anzusprechen.

Wird ein solcher mechanischer Zähler in Form eines Binärzählers als elektronisches Äquivalent ausgebildet, der mindestens k Zellen haben muß, wenn er von 0 bis $2^k$-1 zählen können soll, so tritt ein Problem auf, welches auf der Tatsache beruht, daß jede der Speicherzellen wenigstens ein nichtflüchtig elektrisch programmierbares Speicherelement enthalten müßte, wenn der Zählerstand über Zeiten ohne Betriebsspannung hinweg erhalten bleiben soll.

Die nichtflüchtig lesbaren Halbleiterspeicherelemente, wie MNOS-Feldeffekttransistoren als auch Feldeffekttransistoren mit potentialmäßig schwebender Gateelektrode, haben nämlich die Eigenschaft, daß ihre Speicherfähigkeit mit der Zahl der Umprogrammierungen abnimmt, was als Degradation bezeichnet wird. Deshalb ist nur eine begrenzte Zahl von Programmierzyklen zulässig. In einem elektronischen Zähler mit nichtflüchtiger Speicherung muß bei jedem Weiterzählen die neue Information durch eine Umprogrammierung gespeichert werden. Das Problem liegt also darin, daß in der begrenzten Anzahl der Schreib- Lösch-Zyklen gleichzeitig eine Zählgrenze für die höchste Zahl vorliegt, die mit einem elektronischen Zähler mit nichtflüchtiger Speicherung zu erreichen ist, falls ein Binärzähler herkömmlichen Aufbaus mit elektrisch programmierbaren Halbleiterspeicherelementen verwendet wird.

Bei einfachen Binärzählern mit elektrisch programmierbaren Halbleiterspeicherzellen hat nämlich hinsichtlich der erwähnten Degradation der programmierbaren Speicherelemente folgende zwei Nachteile:

a) Die Anzahl der Umprogrammierungen ist höher als die Anzahl der Zählschritte, weil bei einem Übertrag einer Information mindestens zwei Stufen ihre Information ändern müssen; insgesamt ist die Zahl der Umprogrammierungen etwa doppelt so groß wie die der Zählschritte.

b) Das letzte Bit (LSB) wird am meisten, nämlich bei jedem Zählschritt umprogrammiert und bestimmt dadurch allein die größte zu speichernde Zahl (n-stelliges Digitalwort), welche damit höchstens doppelt so hoch ist (ein Zyklus besteht aus zwei Umprogrammierungen: Schreiben und Löschen) wie die maximale Zeit möglicher Schreib-Lösch-Zyklen eines Speichertransistors.

Aufgabe der Erfindung ist die Angabe eines elektronsichen Zählers mit nichtflüchtiger Speicherung unter Verwendung von elektrisch programmierbaren Halbleiterspeicherelementen der eingangs erwähnten Art, mit welchem Zähler ein großer Zählerstand ohne Verlust der Speicherzeit möglich ist.

Zur Lösung dieser Aufgabe wird bei der Erfindung von dem Grundgedanken ausgegangen, daß ein Matrixspeicher für eine gewisse Anzahl von niedrigwertigen Bits verwendet wird, dessen Speicherzellen mit nichtflüchtig elektrisch programmierbaren Speicherelementen der eingangs erwähnten Art nacheinander programmiert werden, so daß sämtliche Speicherzellen dieses Matrixspeichers gleichmäßig belastet sind. Ein Binärzähler, ebenfalls mit nichtflüchtig elektrisch programmierbaren Speicherelementen, hält dann fest, wie oft die Gesamtmatrix umprogrammiert wurde. Die Anzahl der Zählschritte wird dadurch erhöht, daß

a) bei fast allen Zählschritten nur eine einzige Speicherzelle umprogrammiert wird und

b) fast alle Speicherzellen der gleichen Anzahl von Schreib-Lösch-Zyklen unterzogen werden.

Theoretisch kann, wenn z die Anzahl der Schreib-Lösch-Zyklen ist, die ein Speichertransistor verträgt, bei Aufnahme von N Speichertransistoren in einem Zähler mit nichtflüchtiger Speicherung nach der Erfindung bis auf 2. z. N gezählt werden, wenn auch $2^N$-1 > 2z. N ist, was bei genügend großen N sicher der Fall ist. Dabei ist zu bemerken, daß bei Anordnungen, wo nur ein Teil des Zyklus, etwa nur das Schreiben, für jeden Speichertransistor individuell vorgenommen werden kann, die maximale Anzahl der Zählschritte kleiner ist. Die Erfindung bemüht sich, dieser größtmöglichen Anzahl möglichst nahe zu kommen.

Die oben genannte Aufgabe wird bei einem Zähler mit nichtflüchtiger Speicherung eines n-stelligen Digitalwortes erfindungsgemäß durch die im kennzeichnenden Teil des Patentanspruchs angegebene Ausbildung gelöst.

Die Erfindung wird im folgenden anhand der Zeichnung erläutert,

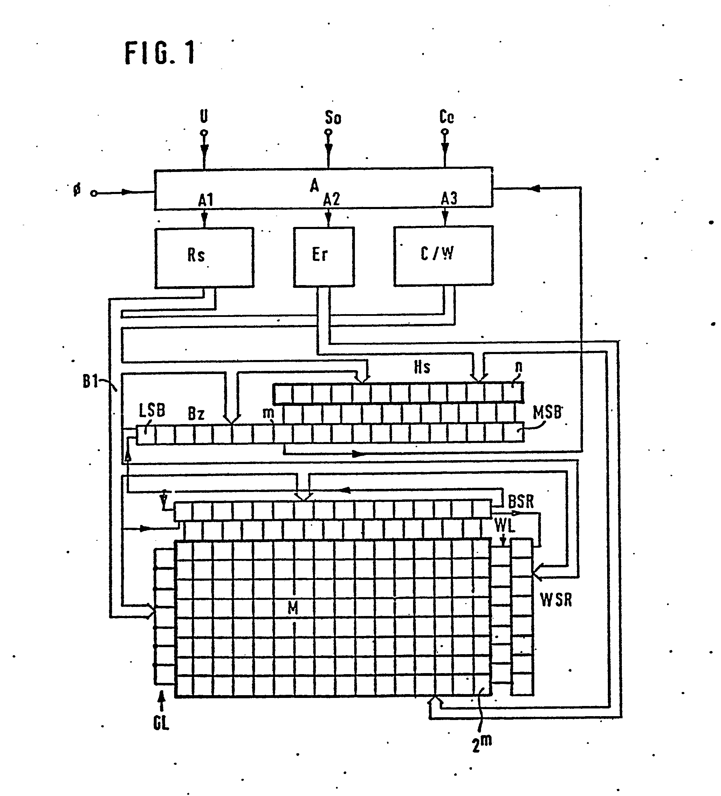

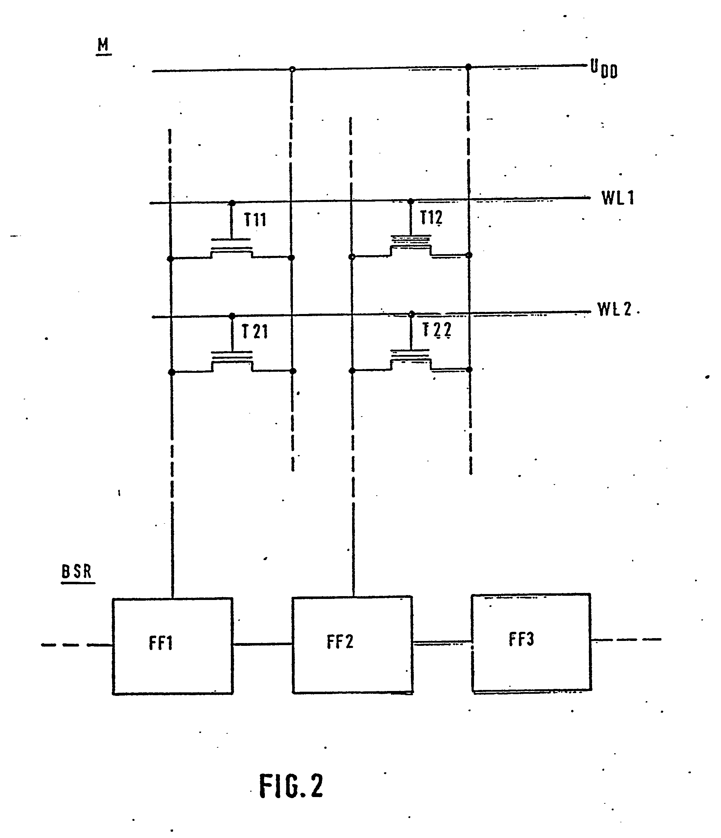

deren Fig. 1 das Blockschaltbild des Zählers nach der Erfindung veranschaulicht und

deren Fig. 2 den Ausschnitt einer Speichermatrix mit dynamischen Speicherzellen zeigt, die je ein nichtflüchtig programmierbares Speicherelement in Form eines MNOS-Feldeffekttransistors enthalten und mit je einer Bitschieberegisterzelle des Zählers nach der Erfindung verbunden sind.

Um die Anzahl der maximal möglichen Zählschritte auf einen möglichst großen Wert zu bringen, ist der Zähler nach der Erfindung in zwei Teile aufgeteilt. Den Hauptteil bildet die Matrix M gemäß der Fig. 2 aus $2^m$ nichtflüchtig elektrisch programmierbaren Speicherelementen, welche je mindestens einen Speichertransistor der eingangs genannten Art enthält. Die $2^m$ Speicherelemente der Speichermatrix M werden bitweise über ein Wortschieberegister WSR und ein Bitschieberegister BSR so angewählt, daß die $2^m$ Speicherelemente der Speichermatrix M bei jedem Zählschritt nacheinander umprogrammiert werden.

Synchron zum Zählvorgang in der Speichermatrix M läuft ein Zählvorgang in dem Binärzähler Bz ab, in dem lediglich eine flüchtige Speicherung möglich ist, da er lediglich nicht programmierbare Schaltungselemente enthält und daher nicht der eingangs erwähnten Degradation unterworfen ist. Der Binärzähler Bz enthält m + n bistabile Speicherzellen, von denen n Speicherzellen vom höchstwertigen Bit MSB aus gerechnet mit je einer nichtflüchtigen Speicherzelle eines Hauptspeichers Hs gekoppelt sind. Der Hauptspeicher Hs enthält wie die Speichermatrix umprogrammierbare Speicherelemente.

Ist das $2^m$-Speicherelement der Speichermatrix M umgeschrieben, so erhält beim nächsten Zählimpuls das m + 1-te Bit des Binärzählers Bz die logische Eins. Dieser Zählimpuls wird, wie die Fig. 1 zeigt an eine $\Phi$ - getaktete Ablaufsteuerung A angelegt und erzeugt am zweiten Ausgang A2 ein Löschsignal, so daß in der mit dem zweiten Ausgang A2 verbundenen Löschpulsstufe Er eine Löschpuls erzeugt wird, und die gesamte Speichermatrix M umprogrammiert wird.

Die Ablaufsteuerung A wird so ausgelegt, daß auch bei Eingeben eines Signals So bei Zählbeginn in die Ablaufsteuerung A am zweiten Ausgang A2 ein erstes Löschsignal auftritt, das nicht nur die Speicherzellen des Hauptspeichers Hs sondern auch die der Speichermatrix M löscht. Es tritt somit dann nach je $2^m$ Zählimpulsen ein zweites Löschsignal am zweiten Ausgang A2 auf, das aber lediglich die Speicherzellen der Speichermatrix M löscht.

In die Ablaufsteuerung A werden außer dem Taktsignal $\Phi$ und das Zählbeginnsignal So die Versorgungsspannung U und bei Co die Zählimpulse angelegt.

Die Ablaufsteuerung wird so ausgelegt, daß bei Zählbeginn oder nach Ausfall der Versorgungsspannung am ersten Ausgang Al ein Rücksetzsignal auftritt, welches über die Rücksetz-Lese-Stufe Rs Rücksetzimpulse erzeugt, die den Binärzähler Bz, das Bitschieberegister BSR und das Wortschieberegister WSR zurücksetzen. Anschließend werden nach vorgegebenen Programm in der Rücksetz/Lese-Stufe Rs Leseimpulse eines Lesezyklus erzeugt, mit deren Hilfe die Informationen im Hauptspeicher Hs und in der Speichermatrix M in den Binärzähler Bz eingeschrieben werden.

Bei Zählbeginn werden die Speichertransistoren sowohl in der Speichermatrix M als auch im Hauptspeicher Hs durch eine Löschzyklus, beispielsweise auf niedrige Schwellspannungs ($U_{DD}$)-Werte, gesetzt, welche logische Nullen repräsentieren sollen. Anschließend läuft dann ein Rücksetz- und Lesezyklus ab, wie er auch bei jedem Spannungsausfall nach dem Einsetzen oder Einschalten der Versorgungsspannung abläuft. Der Binärzähler Bz enthält somit die Binärfolge 000...0, während sowohl das Bitschieberegister BSR als auch das Wortschieberegister WSR auf 100...0 gebracht worden sind.

Durch einen ersten Lesevorgang wird sodann der Inhalt des Hauptspeichers Hs in die Bitstellen m + 1 bis n beschrieben. Ferner wird der Inhalt des ersten Wortes der Speichermatrix M in das Bitschieberegister BSR übernommen. Mit Hilfe des Taktes wird die gesamte im Bitschieberegister BSR enthaltende Information einmal im Ring geschoben und dabei vom Binärzähler Bz registriert. Die Information besteht, wie aus deren noch zu beschreibenden Art des Zählens hervorgeht, aus einem entweder ganz oder nur teilweise mit Einsen besetztem Wort. Nach dem Ringschieben eines voll mit Einsen besetzten Wortes wird das jeweils nächste Wort der Speichermatrix M gelesen, im Ring geschoben und in den Binärzähler Bz eingeschrieben. Nach einem Wort mit mindestens einer Null wird nicht mehr zum nächsten Wort übergegangen, sondern mit dem erreichten Zählerstand im Binärzähler Bz entsprechend dem in der Speichermatrix M vorhandenen Zählerstand auf den normalen Zählbetrieb übergeleitet.

Die Ablaufsteuerung A ist ferner so ausgelegt, daß an dem dritten Ausgang A3 bei jedem Zählimpuls ein Schreibsignal auftritt, bei dem die Gateleitungen GL der Speichermatrix M und der Eingang des Binärzählers Bz über den Bus 81 nach jedem Zählimpuls mit einem Schreibimpuls versorgt wird. Somit wird jeder Zählimpuls sowohl im Binärzähler Bz als auch in der Speichermatrix M registriert. In der Speichermatrix M nimmt eine weitere Speicherzelle entsprechend der vom Wortschieberegister WSR und den Bitschieberegister BSR angewählten Stelle den Zustand der vorhergehenden Speicherzelle ein. Der neue Stand des Bitschieberegisters BSR wird in das im Wortschieberegister WSR durch eine einzelne Eins gekennzeichnete Wort eingeschrieben. Ist das Bitschieberegister BSR voll, wird die Eins im Wortschieberegister WSR um eine Stelle weitergeschoben und das Bitschieberegister BSR normiert (100....0). Sind alle Speicherelemente der Speichermatrix M geschrieben, werden sowohl der Hauptspeicher Hs als auch die Speichermatrix M gelöscht und die im Binärzähler Bz enthaltende Information in den Hauptspeicher Hs eingeschrieben. Danach werden sowohl das Bitschieberegister BSR als auch das Wortschieberegister WSR normiert, d. h. auf (100...0) gebracht.

Im vorstehend erläuterten Beispiel wurde angenommen, daß die nichtflüchtige Speicherung in Speicherzellen erfolgt, die bitweise geschrieben und wortweise gelöscht werden können. Da in der Speichermatrix M sicherlich ohne weiteres 1000 oder 2000 Speichertransistoren integriert werden können, erhöht sich die größte speicherbare Zahl gegenüber der des Binärzählers der eingangs genannten Art mit Speichertransistoren in jeder Stufe um den Faktor $10^3$.

Je nachdem, ob die nichtflüchtigen elektrisch programmierbaren Speicherelemente mit ein- oder zwei- Transistorzellen ob mit bitweise oder zeilenweiser Löschung ausgelegt sind, müssen die Gesamtschaltung und der Programmablauf des Binärzählers Bz leicht geändert werden.

Die Speicherelemente der Speichermatrix M bestehen im einfachsten Fall aus je einem Speichertransistor, beispielsweise einem MNOS-Feldeffekttransistor. Die Fig. 2 zeigt den Ausschnitt der Schaltung einer solchen Speichermatrix mit vier Speicherzellen, die je einen MNOS-Feldeffekttransistor TlI, T12, T21, T22 enthalten. Die Gate-Elektroden der MNOS-Feldeffekttransistoren T11, T12, T21, T22 sind zeilenweise mit den Wortleitungen WL1, WL2 verbunden. Die Source-Elektroden jeweils einer Spalte liegen am Setzeingang einer Flipflop-Zelle FF1, FF2, FF3 des Bitschieberegisters BSR, während die Drain-Elektrode die Versorgungsspannung $U_{DD}$ erhalten.

## Patentanspruch

1. Zähler mit nichtflüchtiger Speicherung eines n-stelligen Digitalwortes, gekennzeichnet

a) durch eine Speichermatrix (M) aus $2^m$ nichtflüchtig elektrisch programmierbaren Speicherelementen, die bitweise über ein Wortschieberegister (WSR) und ein Bitschieberegister (BSR) angewählt werden können,

b) durch einen Binärzähler (Bz) mit m + n bistabilen Speicherzellen, von denen n Speicherzellen vom höchstwertigen Bit (MSB) aus gerechnet mit je einer nichtflüchtigen Speicherzelle eines Hauptspeichers (Hs) gekoppelt sind,

c) durch eine getaktete Ablaufsteuerung (A) mit - einem ersten Ausgang (AI), an dem bei Zählbeginn oder nach Ausfall der Versorgungsspannung ein Rücksetzsignal auftritt, wobei der Binärzähler (Bz), das Bitschieberegister (BSR) und das Wortschieberegister (WSR) zurückgesetzt werden, und an dem anschließend Leseimpulse eines Lesezyklus erzeugt werden, mit denen die Informationen im Hauptspeicher (Hs) und in der Speichermatrix (M) in den Binärzähler (Bz) eingeschrieben werden,

- einem zweiten Ausgang (A2), an dem bei Zählbeginn ein erstes Löschsignal auftritt, das die Speicherzellen des Hauptspeichers (Hs) und der Speichermatrix (M) löscht und an dem nach je $2^m$

Zählimpulsen ein zweites Löschsignal erzeugt wird, das die Speicherzellen der Speichermatrix (M) löscht,

einem dritten Ausgang (A3), -der bei jedem Zählschritt den Eingang des Binärzählers (Bz) mit einem Zählimpuls und die Gateleitungen (GL) der Speichermatrix (M) mit einem Schreibimpuls versorgt.

## Claims

1. A counter for the non-volatile storage of an n-bit digital word, characterized

a) by a storage matrix (M) consisting of $2^m$ non-volatile electrically programmable storage elements which are capable of being bitwisely selected via a word shift register (WSR) and a bit shift register (BSR),

b) by a binary counter (Bz) comprising m + n bistable storage cells of which n storage cells, as counted from the most significant bit (MSB), are each coupled to one non-volatile storage cell of a main storage (Hs),

c) by a clocked sequence control (A) comprising

- a first output (AI) at which, either at the beginning of the counting operation or following the event of a failure of the supply voltage, a reset signal appears, by which said binary counter (Bz), said bit shift register (BSR) and said word shift register (WSR) are reset, and at which, subsequently thereto, there are produced the reading pulses of a reading cycle by which the information as contained in both said main storage (Hs) and said storage matrix (M),is written into said binary counter (Bz),

- a second output (A2) at which, at the beginning of the counting operation, there appears a first erase signal for erasing the storage cells of both said main storage (Hs) and said storage matrix (M), and at which, after each time $2^m$ counting pulses, there is produced a second erase signal for erasing the storage cells of said storage matrix (M),

- a third output (A3), which, at every counting step, supplies the input of said binary counter (Bz) with a counting pulse, and the gate lines (GL) of said storage matric (M) with a write pulse.

## Revendication

1. Compteur pour enregistrer de manière non-volatile un mot numérique à n bits caractérisé par:.

a) une matrice d'enregistrement (M) consistant en $2^m$ éléments à mémoire non-volatile programmables électriquement, pouvant être sélectionnés par bit grâce à un registre à décalage de mot (WSR) et un registre à décalage de bit (BSR),

b) un compteur binaire (Bz) comprenant m + n cellules de mémoire bistables dont n cellules de mémoire, oomptées depuis le bit le plus significatif (MSB), sont couplées chacune à une cellule de mémoire non-volatile d'une mémoire principale (Hs),

c) et une commande séquentielle synchronisée (A) comprenant:

- une première sortie (A1) sur laquelle apparaît, soit au début du comptage ou après que soit survenue une disparition de la tension d'alimentation, un signal de remise à zéro qui remet en position initiale le compteur binaire (Bz), le registre de décalage de bit (BSR) et le registre de décalage de mot (WSR) et sur laquelle sont produites, après cela, les impulsions de lecture d'un cycle de lecture grâce auquel l'information contenue dans la mémoire principale (Hs) et la matrice de mémoire (M) est inscrite dans le compteur binaire (Bz),

- une seconde sortie (A2) sur laquelle apparaît, au début du comptage, un premier signal d'effacement pour effacer le contenu des cellules de mémoire de la mémoire principale (Hs) et de la matrice de memoire (M) et sur laquelle est produit, après à chaque fois $2^m$ impulsions de comptage, un second signal d'effacement pour l'effacement du contenu des cellules de mémoire de la matrice de mémoire (M),

- une troisième sortie (A3) fournissant, à chaque pas de comptage, une impulsion de comptage à l'entrée du compteur binaire (Bz) et une impulsion d'écriture aux portes de rangées (GL) de la matrice de mémoire (M).

# FIG. 1

FIG.2